(19) Europäisches Patentamt
European Patent Office
Office européen des brevets

(11) EP 1 930 965 A1

(12) EUROPEAN PATENT APPLICATION

(43) Date of publication:
11.06.2008 Bulletin 2008/24

(51) Int Cl.:
*H01L 51/52* (2006.01)

(21) Application number: 07075918.8

(22) Date of filing: 23.10.2007

(84) Designated Contracting States:
AT BE BG CH CY CZ DE DK EE ES FI FR GB GR HU IE IS IT LI LT LU LV MC MT NL PL PT RO SE SI SK TR
Designated Extension States:
AL BA HR MK RS

(30) Priority: 23.10.2006 JP 2006287397

(71) Applicant: NEC Lighting, Ltd.
Shinagawa-ku
Tokyo 141-0032 (JP)

(72) Inventor: Toshitaka Mori
c/o NEC Lighting, Ltd.
Shinagawa-ku, TOKYO 141-0032 (JP)

(74) Representative: Mertens, Hans Victor
van Exter Polak & Charlouis B.V.
P.O. Box 3241
NL-2280 GE Rijswijk (NL)

(54) **Electroluminescent device and electroluminescent panel**

(57) An electroluminescent device, including: support substrate 1; a light emitting portion having first electrode 2, light emitting medium 3 and second electrode 4 laminated in this order or the inverse order on support substrate 1; and light scattering portion 5 located at least on the side of light emitting medium 3, containing light scattering fine particle 5a, or light scattering fine particle and fluorescent substance, and having a tapered shape in which a distance from a center of the light emitting portion enlarges upward from the side of support substrate 1, in which, in the light emitting portion, light emitting medium 3 emits light by passing electrical current between first electrode 2 and second electrode 4, and light exiting from light emitting medium 3 and traveling in direction B different from direction A of extracting light is incident on light scattering portion 5 and scattered, or the incident light is absorbed to emit and scatter light, thereby light is extracted from the light scattering portion in direction A.

FIG. 1

**Description**

This application is based upon and claims the benefit of priority from Japanese patent application No. 2006-287397, filed on October 23, 2006, the disclosure of which is incorporated herein in its entirety by reference.

BACKGROUND OF THE INVENTION

Field of the Invention

The present invention relates to an electroluminescent (EL) device improved in luminous efficiency (efficiency of extracting light), such as an organic EL device and an inorganic EL device, and to an electroluminescent panel using the same.

Description of the Related Art

An EL display unit, particularly an organic EL display unit, has advantages of wide viewing angle and high speed of response because of a self-luminous device. Also, a backlight unit is unnecessary, allowing for a thinner and lighter-weight display unit. In view of these points, recently, an organic EL display unit attracts attention as an alternative to a liquid crystal display unit, and further for illumination.

An organic EL device, which is a main part of an organic EL display unit, includes an optically transparent front electrode, a back electrode that is opposed to the front electrode, and light reflective or optically transparent, and an organic substance layer including a light emitting layer intervening in them. The organic EL device is a self-luminous device of charge injection type that produces luminescence due to electric current flowing in the organic substance layer. To display on the organic EL display unit, it is necessary to cause light emitted from a light emitting medium to exit from the front electrode. A component of the light from the light emitting medium propagating in the direction parallel to the two electrodes and a component totally reflected by an interface between a transparent substrate on the side of extracting light and the atmosphere have a large light intensity. Therefore light exiting from the front face of the device loses light intensity, and the quantity of lost light reaches 70 to 80% of the total quantity of light, from the measurement results.

In an organic EL device, because of an effect of the refractive index of a light emitter thereof, light having an exit angle equal to or larger than a critical angle cannot be extracted externally due to total reflection. Therefore, only about 20% of the total quantity of emitted light can be effectively used, so that efficiency has to be lower (see Tetsuo Tsutsui, "Present Situation and Trend of Organic Electroluminescence", Monthly DISPLAY, Vol. 1, No. 3, p11, Sep. 1995). The details are: a quantity of light in thin film propagation (reflection in interface between transparent electrode and glass substrate) is 50% of the total quantity of emitted light, a quantity of light in substrate propagation (reflection in interface between glass substrate and the atmosphere (air)) is 30%, and a quantity of light extracted externally is small to the degree of about 20% (see G. Gu, S. R. Forrest, Optics Lett., 22 (1997) 396). As mentioned above, much of light emitted from an emitting layer cannot be extracted externally from the organic EL device, presenting a problem of low efficiency of extracting light.

To enhance the efficiency of extracting light externally, JP-A-11-283751 describes that, in light traveling to a front face in a device, light traveling to a region having a wide angle is refracted by using a diffraction device or a zone plate to pass through an interface of a front electrode. This technique can enhance the efficiency of extracting light of an organic EL device. However, according to the technique disclosed in this document, images may be improperly displayed as an organic EL display unit, because a pattern constituting the diffraction device or the zone plate has directional characteristics, so that directivity of extracted light changes dependent on the direction. Moreover, fine features of the diffraction device or the zone plate have to be formed by lithography etc., also causing a problem of an increased cost.

Another approach to enhancing the efficiency of extracting light includes, for example, a proposed method using a fine particle dispersion layer (JP-A-2006-107744). However, because the fine particle dispersion layer is provided between a transparent substrate and a front electrode, light emitted in a light emitting layer is reflected by both electrodes to propagate in the lateral direction. Further, because the fine particle dispersion layer is situated in the direction of extracting light, light exiting in the front direction is scattered to generate a component of light having an angle of not smaller than a critical angle, presenting a problem in terms of a decreased light emitting rate. Therefore, the efficiency of extracting light of a device including the conventional fine particle dispersion layer is not sufficiently enhanced.

Then, there has been proposed a method that, in the lateral direction different from the direction of extracting light, a rectangular, fluorescent film was provided (JP-A-2005-71920). However, there are a problem of propagation loss caused from an effect of refractive indexes of a light emitting portion and the fluorescent film, and a space created between the light emitting portion and the fluorescent film due to a shape of the fluorescent film, and further a problem of light reflection by an interface of a support substrate caused from a difference of refractive indexes of the fluorescent film and the support substrate. In this case, also, the efficiency of extracting light is not sufficiently enhanced.

JP-A-06-151061 discloses an EL device made of substantially the same material as a light emitting layer of an inorganic EL device, formed continuously with the light emitting layer, and including a light propagating layer having light scattering means for scattering light propagating from the light emitting layer outside of the device. Concerning the light scattering means, it is described that a scattering particle is dispersed in the light propagating layer, but it is not disclosed how the scattering particle is dispersed in the light propagating layer.

Another related art includes an art disclosed in JP-A-2003-303677.

SUMMARY OF THE INVENTION

The present invention has been made in view of the circumstances described above, and an object thereof is to provide an EL device (organic EL device) having luminous efficiency (efficiency of extracting light) enhanced.

The present invention to solve the problems described above provides an electroluminescent device and an electroluminescent panel including:

a support substrate;

a light emitting portion in which a first electrode, a light emitting medium and a second electrode are laminated in this order on the support substrate; and

a light scattering portion located at least on the side of the light emitting medium, containing a light scattering fine particle, or the light scattering fine particle and fluorescent substance, and having a tapered shape enlarging upward from the side of the support substrate,

wherein, in the light emitting portion, the light emitting medium emits light by passing electrical current between the first electrode and the second electrode, and

light exiting from the light emitting medium and traveling in the direction different from a direction A of extracting light is incident on the light scattering portion and scattered, or is absorbed to emit and scatter light, thereby light is extracted from the light scattering portion in the direction A.

That is, according to the present invention, a light scattering medium is not provided in the direction of a film thickness (longitudinal direction) of the light emitting medium, but provided in the lateral direction of the light emitting medium.

In the EL device of the present invention, because a component of emitted light having a large exit angle can be effectively extracted externally, an EL device and an EL panel improved in efficiency of extracting light can be provided.

BRIEF DESCRIPTION OF THE DRAWINGS

FIG. 1 is a conceptual diagram for describing a structure of an EL device of a first exemplary embodiment according to the present invention;

FIG. 2 is a conceptual diagram for describing a structure of an EL device including a first light scattering portion and a second light scattering portion;

FIG. 3 is a plan view illustrating a configuration in which a light scattering portion is disposed around a light emitting portion;

FIG. 4 is a plan view illustrating a configuration in which the first light scattering portion and the second light scattering portion are disposed around the light emitting portion;

FIG. 5 is a cross-sectional view schematically illustrating a configuration of an EL device in which a microfabricated resin medium (film) is attached to a contact surface of a support substrate with the surrounding;

FIG. 6 is a cross-sectional view schematically illustrating a configuration of an EL device in which the light scattering medium (fine particle dispersion layer) is formed on the contact surface of the support substrate with the surrounding;

FIG. 7 is a process, cross-sectional view for describing a method for manufacturing the EL device of one exemplary embodiment;

FIG. 8 is a partial cross-sectional view illustrating one exemplary embodiment of the EL device of the present invention;

FIG. 9 is a partial cross-sectional view illustrating another exemplary embodiment of the EL device of the present invention; and

FIG. 10 is a partial cross-sectional view illustrating further another exemplary embodiment of the EL device of the present invention.

DETAILED DESCRIPTION OF THE EXEMPLARY EMBODIMENTS

Now, exemplary embodiments of the present invention will be hereinafter described in detail with reference to the accompanying drawings.

[First Exemplary Embodiment]

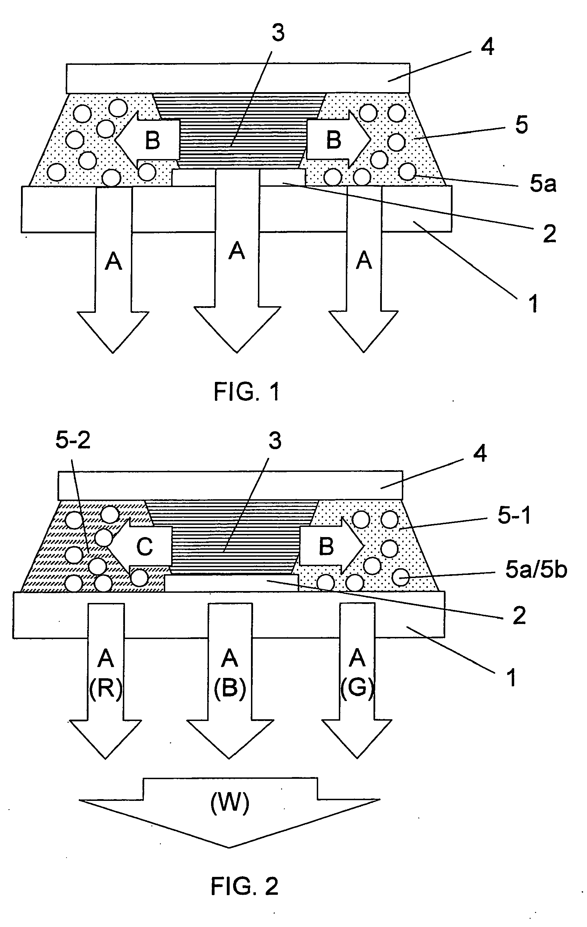

FIG. 1 is a conceptual diagram for describing a configuration of an EL device of a first exemplary embodiment according to the present invention. In FIG. 1, on an optically transparent support substrate 1, a first electrode 2 is formed in stripe geometry, and a light emitting medium 3 is sandwiched between the first electrode 2 and a second electrode 4 opposite to it. Here, by injecting electron holes from the first electrode 2 and electrons from the second electrode 4, electron holes and electrons are recombined in the light emitting medium 3 to emit light. The emitted light is extracted externally in a direction A through the optically transparent first electrode 2 and support substrate 1. Also, a part of the emitted light in the light emitting medium 3 exits in direction B, and further, is reflected by an interface of the support substrate 1 and the atmosphere, also reflected by an interface of the support substrate 1 and the first electrode 2, and further incident on a light scattering portion 5 containing a light scattering fine particle 5a on the side of the light emitting medium 3. Features of the present invention reside in that the light scattering portion 5 contains at least the light scattering fine particle 5a and is formed in a tapered shape (trapezoidal). At this time, because the light scattering fine particle 5a is contained in the light scattering portion 5, the incoming light from the direction B is scattered, and thereby, also from the light scattering portion 5, the light can be extracted in the direction A of extracting light. Further, according to the present invention, because the shape of the light scattering portion 5 is tapered, there is not an air gap between the light scattering portion 5 and the light emitting medium 3 formed after forming the light scattering portion 5, providing an advantage of excellently guiding a wave to the light scattering portion 5. Moreover, also concerning the second electrode formed to bridge across each pixel in the direction perpendicular to the first electrode, there is also brought out an advantage that the second electrode can be formed without breaking of wire, because the light scattering portion 5 is formed in the tapered shape. When the light scattering portion 5 contains only the light scattering fine particle 5a, an emission wavelength in the light emitting medium 3 can be directly extracted from the light scattering portion 5 in the direction A of extracting light. Further, fluorescent substance (5b) may also be added to the light scattering portion 5, in addition to the light scattering fine particle 5a, and in this case, light incident on the light scattering portion 5 is scattered by the light scattering fine particle and excites the fluorescent substance to produce fluorescence, and then the light can be extracted in the direction A of extracting light, as light having a different wavelength from the emission wavelength in the light emitting medium 3.

[Second Exemplary Embodiment]

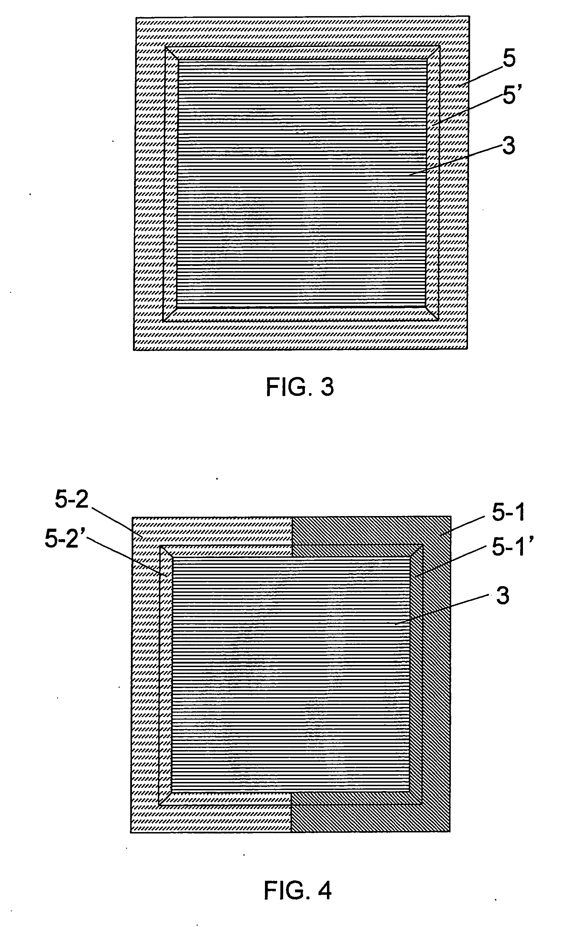

FIG. 2 is a conceptual diagram for describing a configuration of an EL device of a second exemplary embodiment of the present invention. Points different from the first exemplary embodiment shown in FIG. 1 reside in that a light emitting portion contains a light emitting medium 3 for emitting blue light, and includes a first light scattering portion 5-1 in a direction B toward the light emitting medium 3, and a second light scattering portion 5-2 using fluorescent substance different from fluorescent substance of the first light scattering portion in a direction C opposite to the direction B, in which the first light scattering portion 5-1 and the second light scattering portion 5-2 have a luminescent color different from each other, and three kinds of pixel are used, that is, a blue (B) pixel contained in the light emitting portion, a green (G) pixel in the first light scattering portion 5-1 and a red (R) pixel in the second light scattering portion 5-2. As the result, blended light, which is emitted by using a configuration including the three kinds of pixel (three primary colors) of the light emitting portion, the first and second light scattering portions, is white (W) light.
The first and second exemplary embodiments have been described referring to the case where the direction A of extracting light is set to the direction from the side of the support substrate 1 as an example, but not limited to this, the light may be extracted in the direction opposite to the direction toward the support substrate 1, or also in both directions. In the case of extracting light in one direction, it is preferable that material provided on the side of extracting light is transparent material, and a light reflecting layer is provided on the opposite side. The light reflecting layer is preferably a reflecting electrode formed of an electrode on the side different from the side of extracting light, more preferably a reflecting electrode extending also on the side of the light scattering portion. Particularly preferably, a reflecting electrode is desirably formed to surround an upper end portion of the trapezoidal, light scattering portion, enhancing a photon confinement effect.
The description described above has shown an example that, in a gap in the first electrode formed in the stripe geometry, the light scattering portion is formed similarly in the stripe geometry, but the light scattering portion, similarly to a fluorescent film disclosed in JP-A-2005-71920 described above, may be formed to surround the light emitting portion. In FIG. 3, as a modified exemplary embodiment of the first exemplary embodiment, the light scattering portion 5 is formed to surround the light emitting portion (light emitting medium 3). A tapered plane 5' is formed on the inside in contact with the light emitting medium 3. Further, in FIG. 4, as a modified exemplary embodiment of the second exemplary embodiment, the first light scattering portion 5-1 and the second light scattering portion 5-2 are formed to surround the light emitting portion (light emitting medium 3), and a tapered plane 5-1' and a tapered plane 5-2' are formed on the inside of each of them. As mentioned above, by forming the light scattering portion to surround the light emitting portion, there can be provided an EL device having a further excellent efficiency of extracting light.

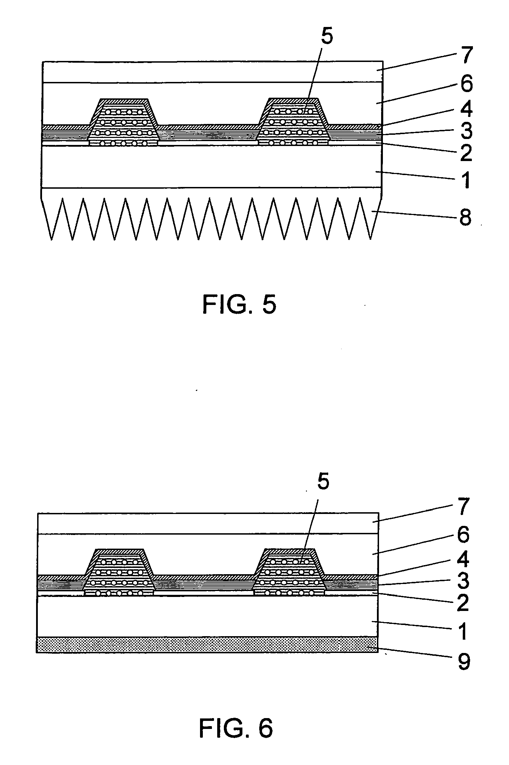

Furthermore, by placing a microfabricated resin medium 8 (see FIG. 5) and/or a light scattering medium 9 (see FIG. 6) between the side of extracting light of the EL device and the surrounding of the atmosphere, and/or at an position in contact with the EL device, the effect of extracting light can be further enhanced. In addition, FIGS. 5, 6 show also an example that, on the second electrode 4, sealing material 6 using material such as ultraviolet curing resin and a protective substrate 7 such as a glass substrate are formed. Also, in these examples, on the side of the support substrate 1, the microfabricated resin medium 8 or the light scattering medium 9 are provided, but they may be provided on the side of the protective substrate 7, when the direction of extracting light is the direction opposite to the direction toward the support substrate.

A system for driving each pixel, of course, includes a conventionally known system such as a simple matrix system or an active matrix system having an active device such as a thin-film transistor (TFT) for switching each pixel. In the case of luminescence of entirely the same color, for example, when used as lighting equipment or a backlight unit, any of the first electrode and the second electrode may also be formed entirely as a common electrode.

[Manufacturing Method]

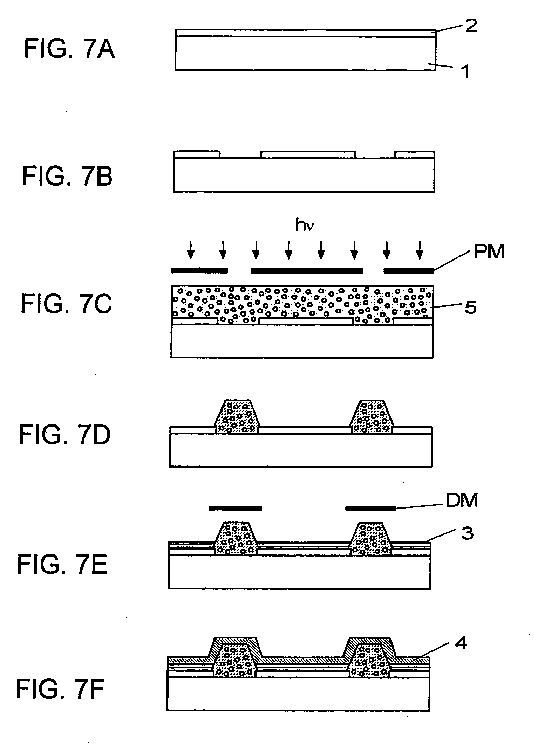

One exemplary embodiment of a method for manufacturing the EL device according to the present invention will be described with reference to FIG. 7. First, transparent, electrically conductive material such as indium tin oxide (ITO) is deposited on a transparent substrate 1 to form a film (process (A)), and the film is pattered in stripe geometry to form the first electrode 2 (process (B)). Next, binder material containing the light scattering fine particle 5a, or the light scattering fine particle 5a and fluorescent substance 5b is entirely applied (process (C)), and the binder material is pattered by photolithography technique to open a portion above the first electrode 2 formed in the stripe geometry. In the present invention, because the binder material contains the light scattering fine particle 5a, a resultant shape of the pattern is likely to be different from a rectangular pattern usually created by photolithography technique. Here, an example is shown that a negative photosensitive resin is used as the binder material and a photomask PM is used to expose, and subsequently, an aromatic organic solvent is used to develop. At this time, by adjusting a developing time, the tapered shape can be controlled. That is, in the upper portion, a width thereof will be formed as specified by the mask PM, but as approaching the lower portion, light is more scattered, so-called a skirt shape is provided. Because a density of cross-linkage becomes lower, as approaching the lower portion, when the developing time is shortened, a forward tapered shape (trapezoidal shape) expanding downward (toward the first electrode) from an exposed surface is formed, and as the developing time is longer, the lower portion having a lower density of cross-linkage is more easily removed. As described above, by setting the developing time to be shorter, the light scattering portion 5 in the forward tapered shape can be provided (process (D)). Subsequently, to further cure the photosensitive resin used for the binder material, it is preferably processed by heat. In the substrate having the light scattering portion 5 provided thereon, after a surface of the first electrode 2 is cleaned using UV ozone etc., a deposition mask DM is placed over the light scattering portion 5 to shield and the light emitting medium 3 is formed on the first electrode 2 by means of vacuum deposition etc. (process (E)). Then, metal for the second electrode is formed in a shape of the second electrode by means of deposition etc. through a mask for the second electrode (not shown) (process (F)). Subsequently, a layer of sealing material (not shown) and a substrate etc. are laminated to form an EL device. Further, by providing electrical connection to each electrode, a control circuit and a power supply etc., an EL panel is finished. In the exemplary embodiment described above, an example has been shown that the first electrode 2 was formed on the support substrate 1, but on the contrary, the second electrode 4 may be formed on the support substrate 1, and the light emitting medium 3 and the first electrode 2 may be formed.

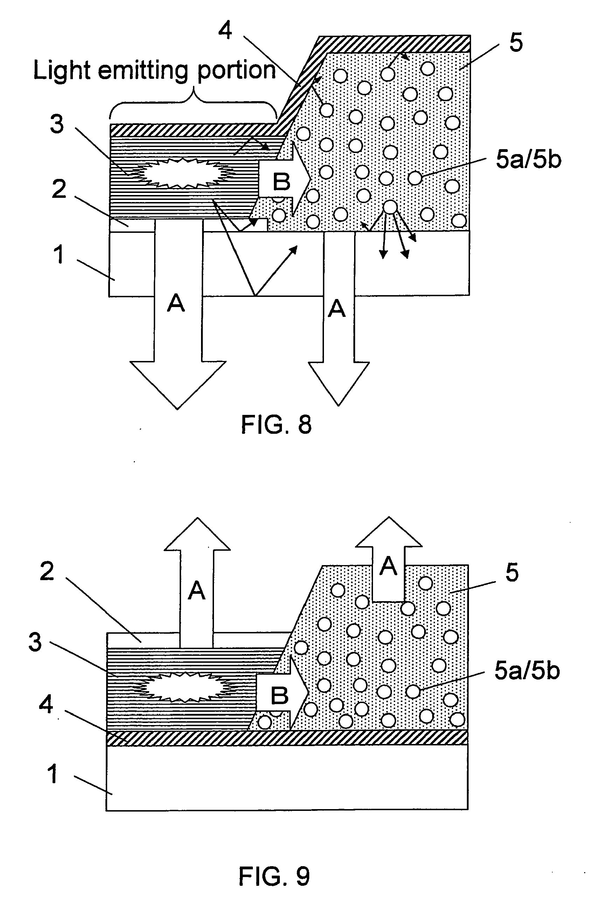

A specific configuration includes configurations shown in FIGS. 8 to 10. In FIG. 8, the configuration made by using the method shown in FIG. 7, and the first electrode 2 is a transparent electrode, the second electrode 4 is formed as a reflecting electrode, and the direction A of extracting light is the direction toward the support substrate 1. A region where the light emitting medium 3 is formed is a light emitting portion. Light emitted by the light emitting portion is divided into light mainly extracted directly in the direction A of extracting light and light traveling in the lateral direction B, and the light in the direction B can be incident on the light scattering portion 5 and scattered by the light scattering fine particle 5a, or absorbed by the fluorescent substance 5b and extracted in the direction A as light having another wavelength. Further, light reflected by an interface between the first electrode 2 and the support substrate 1, an interface between the support substrate 1 and the atmosphere, and a surface of the second electrode 4 can be also incident on the light scattering portion 5 and extracted in the direction A of extracting light.

FIG. 9 shows an exemplary embodiment that light is extracted in the direction opposite to the direction toward the support substrate 1, and also an exemplary embodiment that the second electrode 4 is formed on the support substrate and the first electrode 2 is formed on the light emitting medium 3. Also in this case, light coming from the light emitting portion in the direction B is scattered or converted into light having another wavelength in the light scattering portion 5, and extracted in the direction A of extracting light.

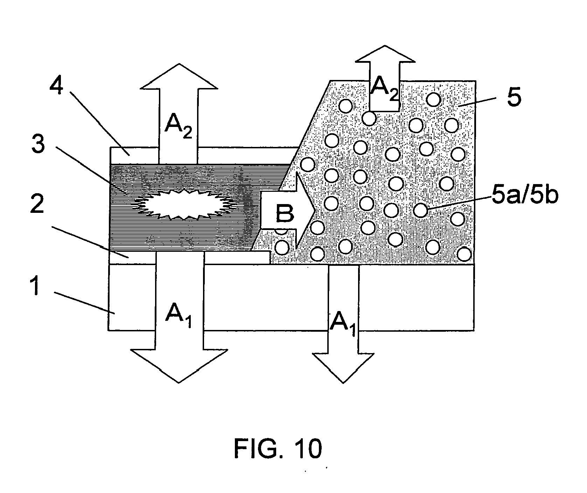

FIG. 10 shows an exemplary embodiment that the second electrode 4, which is formed to cover the light scattering portion 5 in the exemplary embodiment shown in FIG. 8, does not have its electrode formed on the light scattering portion 5. Further, the direction in which light can be extracted includes both the direction $A_1$ from the side of the support substrate 1 and the direction $A_2$ opposite to the support substrate 1.

As shown in FIGS. 8 and 9, the reflective electrode is preferably formed to overlap with the light scattering portion 5, and especially, as shown in FIG. 8, the reflective electrode is preferably formed to cover the upper end portion of the trapezoidal, light scattering portion, because the photon confinement effect becomes high and the efficiency of extracting light in the light scattering portion 5 is enhanced.

[Constituent Material]

{Support Substrate}

The support substrate is a member for supporting the light emitting portion and the light scattering portion, and for that purpose, is preferably a member having superior mechanical strength and dimensional stability. Material for the support substrate is selected from inorganic material and organic material. Inorganic material includes, for example, a glass plate, a metal plate and a ceramic plate. Organic material includes various resin plates. Transparent material is used when light is extracted from the side of the support substrate.

{Light Emitting Portion}

(First Electrode)

The first electrode plays a role as a positive electrode in mainly injecting electron holes into the light emitting medium, and in the organic EL device, material having a work function having not smaller than 4.5 eV is effective. For example, metals and oxides thereof such as indium tin oxide (ITO) alloy, tin oxide (NESA), gold, silver, platinum and copper, and mixture thereof are usable. Optically transparent material such as ITO is used when light is extracted from the side of the support substrate.

(Second Electrode)

The second electrode plays a role as a negative electrode in mainly injecting electrons into the light emitting medium, and in the organic EL device, material having a work function having a small value is effective. For example, indium, aluminum, magnesium, magnesium-indium alloy, magnesium-aluminum alloy, aluminum-lithium alloy, aluminum-scandium-lithium alloy, magnesium-silver alloy and mixture thereof are usable.

(Light Emitting Medium)

The light emitting medium is a medium containing a light emitting layer where electrons and electron holes can be recombined to produce EL, and is divided into an organic system and an inorganic system dependent on material used. The EL device includes, for example, the following layer configurations.

(1) first electrode/light emitting layer/second electrode
(2) first electrode/electron hole transporting layer/light emitting layer/second electrode
(3) first electrode/light emitting layer/electron transporting layer/second electrode
(4) first electrode/electron hole transporting layer/light emitting layer/electron transporting layer/second electrode

Also, the light emitting layer may be formed of a plurality of layers that emit different colors from each other, respectively.

Luminescent material used for the organic EL device especially has no limitation, and any of chemical compounds usually used for luminescent material is usable. For example, tris(8-quinolinol) aluminum complex (Alq3), bisdiphenyl vinyl biphenyl (BDPVBi), 1,3-bis (p-t-butylphenyl-1,3,4-oxadiazoyl) phenyl (OXD-7), N,N'-bis(2,5-di-t-butylphenyl) perylene tetracarboxylic acid diimide (BPPC), and 1,4-bis(p-tolyl-p-methylstyryl phenyl amino) naphthalene are included.

Electron hole transporting material used for the present invention especially has no limitation, and any of chemical compounds usually used for electron hole transporting material may be used. For example, triphenyl diamines such as bis(di(p-tolyl)aminophenyl)-1,1-cyclohexane, 4,4'-bis(m-tolylphenylamino)biphenyl (TPD), N,N'-diphenyl-N,N'-bis(1-naphthyl)-1,1'-biphenyl)-4,4'-diamine ($\alpha$-NPD), and molecules of star-burst type are included.

Electron transporting material used for the present invention especially has no limitation, and any of chemical compounds usually used for electron transporting material may be used. For example, oxadiazole derivatives such as 2-(4-biphenylyl)-5-(4-t-butylphenyl)-1,3,4-oxadiazole (Bu-PBD) and OXD-7, triazole derivatives, and metal complexes of quinolinol system are included.

On the one hand, luminescent material used for the inorganic EL device especially has no limitation, and conventionally known material is usable. For example, calcium thiogallate to which cerium (Ce) is added ($CaGa_2S_4$: Cs) and strontium sulfide to which copper (Cu) is added (SrS: Cu) are included.

{Light Scattering Portion}

The light scattering portion includes at least one kind of fine particle and at least one kind of binder material. The fine particle has fine particles (light scattering fine particles) having a light scattering function in the visible region dispersed therein. Fluorescent substance may be dispersed or dissolved in the binder material. The refractive index of the light scattering portion is preferably higher than at least any one of those of the light emitting medium, the first electrode and the second electrode.

A film thickness of the light scattering portion especially has no limitation, and the film thickness may be formed thick sufficiently at least to form the light emitting portion using means such as deposition. Typically, the film thickness is formed to be 0.1 $\mu$m to 50 $\mu$m. An amount of the at least one kind of fine particle contained in the light scattering portion is preferably 0.1% to 80% by volume.

A higher refractive index of the fine particle than that of the binder material can control the refractive index of the light scattering portion at concentration of contained fine particle. The light scattering fine particle has especially no limitation in relation to material as long as a wavelength in the visible region is scattered, and the material thereof preferably includes inorganic oxide such as $TiO_2$, $ZrO_2$ and ZnO, inorganic nitride, inorganic oxynitride, and metal fine particles of Au, Pt and Ag, and the average grain size is preferably 100 to 400 nm.

For the fluorescent substance, any substance that can absorb emitted light in the light emitting portion to produce fluorescence is usable. The fluorescent substance may be divided into organic fluorescent substance and inorganic fluorescent substance. The organic fluorescent substance, as a general rule, has a high fluorescence yield, and on the one side, the inorganic fluorescent substance is superior in durability. A fluorescent wavelength of the fluorescent substance generally appears on the side of a long wave of an absorption wavelength (incident light). Accordingly, fluorescent substance that can absorb emitted light in the light emitting medium (light in the ultraviolet region may be included, in addition to light in the visible region) to produce fluorescence having a desired wavelength is suitably selected.

For example, white luminescence can be produced by using fluorescent substance that produces fluorescence having a complementary color to the emitted light in the light emitting medium in combination with the light emitting medium, and luminescence of various colors including white light can be produced by adjusting an additive amount of fluorescent substance, where the emitted light in the light emitting medium is blue light, and two different, fluorescent colors in the light scattering portion are red and green, as shown in FIG. 2.

The organic and inorganic fluorescent substance may include ones described in JP-A-2005-71920 described above. Further, for the inorganic fluorescent substance, fine particle-like substance may be preferably used, and in this case, the average grain size is preferably 50 nm to 10 $\mu$m.

The binder described above may be selected from inorganic compounds and organic compounds having light transparency. The inorganic compounds may include inorganic oxide, inorganic nitride and inorganic oxynitride. The organic compounds may include various resin material, and are preferably resin material having photosensitivity because of easy processing. For the resin material having photosensitivity, various, light transparent resist material may be used. Also, the binder material itself may have luminescence. Such binder material may include resin material in which a luminescent compound residue is introduced into side chains of high polymer.

While the invention has been particularly shown and described with reference to exemplary embodiments thereof, the invention is not limited to these embodiments. It will be understood by those of ordinary skill in the art that various changes in form and details may be made therein without departing from the spirit and scope of the present invention as defined by the claims.

The present invention will be hereinafter described further specifically with reference to Examples, but the present invention is not limited to the description of these Examples. In addition, in the Examples and Comparative Examples, external quantum efficiency may be obtained from the following expression, based on a ratio of the number of photons (Np) radiated externally from the EL device per unit time to the number of electrons (Ne) injected into the EL device per unit time.

## External quantum efficiency = Np/Ne

Np may be obtained from measurement of optical spectrum, and in the present invention, the measurement was conducted in an integrated sphere.

(Example 1)

The EL device was manufactured according to the processes shown in FIG. 7.

(Formation of First Electrode)

For the support substrate, a transparent glass substrate (non-alkali glass NA35 from NH TECHNO GLASS CORPORATION) having a length of 50 mm x a width 50 mm and a thickness of 0.7 mm was prepared. After this transparent glass substrate was ultrasonically cleaned using acetone and pure water, and dried, a transparent electrode having a thickness of 130 nm was formed by spattering indium tin oxide (ITO) entirely thereon (process (A)). Then, photosensitive resist (OFPR-800 from TOKYO OHKA KOGYO CO., LTD.) was applied onto the transparent electrode described above, and processes of mask exposing, developing (using NMD3 (developer) from TOKYO OHKA KOGYO CO., LTD.) and etching were carried out, forming the first electrode having a width of 70 $\mu$m and a pitch of 100 $\mu$m in a stripe pattern (process (B)). The refractive index of the support substrate was 1.5 and the refractive index of the first electrode was 1.8.

(Formation of Light Scattering Portion)

Transparent binder material was mixed with the fine particles TiO$_2$ (the refractive index 2.7) having different, average grain sizes (weight ratio 100 nm: 200 nm: 300 nm: 400 nm = 1: 1: 2: 2), and the mixed fine particles were dispersed in binder material by volume ratio of 30%. Here, for the transparent binder material, photosensitive negative photoresist (resist of isopropylene rubber base; name of article "OMR") from TOKYO OHKA KOGYO CO., LTD. was used and a film was formed by using a normal spin-coat method. At that time, the rotation speed of the spin coat was set to 1000 rpm. Subsequently, the photoresist was heated by an oven to remove solvent therefrom, and exposed using a photomask having a width of 15 $\mu$m and a pitch of 100 $\mu$m, then developed for five minutes, making a forward tapered structure. For developing, xylene was used. Observing a cross section by means of a scanning electron microscope (SEM), it was confirmed that the forward tapered trapezoid having a width of the bottom of about 30 $\mu$m and a width of the upper portion of about 15 $\mu$m was formed. After developing, it was cleaned using butyl acetate. Finally, heat treatment was performed at 150°C for 30 minutes. This light scattering portion had a height of 8 $\mu$m and the refractive index of the light scattering portion was 1.9.

(Formation of Light Emitting Medium)

After the substrate in which the first electrode and the light scattering portion were provided on the support substrate was cleaned using UV ozone, the light scattering portion was covered with a mask, and the light emitting medium including an electron hole transporting layer, an yellow light emitting layer, a blue light emitting layer and an electron transporting layer was formed on the first electrode (process (F)).
That is, for the electron hole transporting layer, electron hole transporting material, $\alpha$-NPD (from CHEMIPRO KASEI KAISHA, LTD.), was deposited by a thickness of 50 nm. For the yellow light emitting layer, $\alpha$-NPD and rubrene (from CHEMIPRO KASEI KAISHA, LTD.) were deposited by means of double evaporation by a thickness of 20 nm with a film thickness ratio of rubrene being 5%. For the blue light emitting layer, sublimed, refined 9,10-di($\beta$-naphthyl) anthracene [DNA] (from Sigma-Aldrich Co.), and sublimed, refined perylene (from Sigma-Aldrich Co.) were deposited by means of double evaporation by a thickness of 30 nm with a film thickness ratio of perylene being 2%. For the electron transporting layer, electron transporting material Alq3 (from CHEMIPRO KASEI KAISHA, LTD.) was deposited by a thickness of 30 nm. The refractive index of the light emitting medium was 1.7 to 1.8 on an average.

(Formation of Second Electrode)

Finally, the mask covering the light scattering portion was removed, and Mg-Ag alloy (Mg: Ag = 10: 1) was deposited by a thickness of 100 nm on the light emitting medium and the light scattering portion using a predetermined mask for forming the second electrode, and further, on them, Ag was deposited by a thickness of 100 nm, forming the second electrode. Finally, it was sealed with a glass substrate and UV curing resin separately prepared, manufacturing the EL device (process (G)).

(Result)

When a voltage of 8V was applied across the first electrode and the second electrode of the resultant EL device, the EL panel produced white light, and at this time, the external quantum efficiency was about 2.2%.

(Comparative Example 1)

An EL device was manufactured similarly to Example 1, but the fine particles $TiO_2$ were not contained in the light scattering portion, and also a mask having a width of 30 $\mu$m and a pitch of 100 $\mu$m was used as the photomask. The light scattering portion was formed to be a rectangular shape having a width of 30 $\mu$m. When a voltage of 8 V was applied to this EL device, the EL panel produced white light, and at this time, the external quantum efficiency was about 1.6%. Comparing to the results of Example 1, it was found that providing the light scattering portion in which the fine particles having a light scattering function were dispersed improved the efficiency of extracting light.

(Example 2)

A light scattering portion was formed according to the processes similar to Example 1, but red fluorescent pigments (rhodamine 6G from Sigma-Aldrich Co.) were added to the binder material containing the fine particles $TiO_2$ of Example 1. Subsequently, an EL device having the light emitting portion including the electron hole transporting layer, the blue light emitting layer and the electron transporting layer, but not the yellow light emitting layer was made according to the processes similar to Example 1. A thickness of the blue light emitting layer was set to 50 nm. When a voltage of 8 V was applied to this EL device, the EL panel produced white light, and at this time, the external quantum efficiency was about 2.5%.

(Comparative Example 2)

An EL device was manufactured similarly to Example 2, but the fine particle $TiO_2$ was not contained in the light scattering portion and a mask having a width of 30 $\mu$m and a pitch of 100 $\mu$m was used as the photomask. The light scattering portion was formed to be a rectangular shape having a width of 30 $\mu$m. When a voltage of 8 V was applied to this EL device, the EL panel produced white light, and at this time, the external quantum efficiency was about 2.3%. Comparing to the results of Example 2, it was found that, by dispersing the fine particles having a light scattering function, in addition to the fluorescent substance, the efficiency of extracting light was improved.

(Comparative Example 3)

An EL device was manufactured similarly to Example 2, except that a mask having a width of 30 $\mu$m and a pitch of 100 $\mu$m was used as the photomask, and a shape of the light scattering portion of Example 2 was formed by adjusting the developing time to have a height of 8 $\mu$m, a width of the lower portion (on the side of the support substrate) of 30 $\mu$m and a width of the upper portion of 30 $\mu$m. When a voltage of 8 V was applied to this EL device, the EL panel produced white light, and at this time, the external quantum efficiency was about 2.4%. Comparing to Example 2, it was found that a trapezoidal shape of the light scattering portion brought out a higher efficiency of extracting light.

(Comparative Example 4)

An EL device was manufactured similarly to Example 2, except that a mask having a width of 30 $\mu$m and a pitch of 100 $\mu$m was used as the photomask, and a shape of the light scattering portion of Example 2 was formed by adjusting the developing time to have a height of 8 $\mu$m, a width of the lower portion (on the side of the support substrate) of 15 $\mu$m, and a width of the upper portion of 30 $\mu$m. When a voltage of 8 V was applied to this EL device, the EL panel produced white light, and at this time, the external quantum efficiency was about 2.4%. From the results, it was found that an inverted trapezoidal shape of the light scattering portion generated a fracture in the second electrode and a space between the light emitting medium and the light scattering portion, reducing an effect of guiding a wave to the light scattering portion, and therefore the trapezoidal shape of the light scattering portion brought out a higher efficiency of extracting light.

(Example 3)

A first light scattering portion and a second light scattering portion were formed according to the processes of the photolithography process similar to Example 1 by adding red, fluorescent pigments (rhodamine 6G from Sigma-Aldrich Co.) to the binder material containing the fine particles $TiO_2$ of Example 1 and separately using a solvent in which green, fluorescent pigments (coumarin 6 from Sigma-Aldrich Co.) was added to the binder material containing the fine particles $TiO_2$ so that the first light scattering portion containing rhodamine 6G and the second light scattering portion containing coumarin 6 were formed alternately to the first electrode (FIG. 2). Subsequently, an EL device emitting blue light was made according to the processes similar to Example 2. When a voltage of 8 V was applied to this EL device, the EL panel produced white light, and at this time, the external quantum efficiency was about 2.6%. From the results, it was found that emitting the three primary colors more improved the efficiency of extracting light.

(Example 4)

A light scattering portion was formed according to the processes similar to Example 1 by dispersing inorganic, fluorescent substance fine particles (YAG) in the binder material containing the fine particles $TiO_2$ of Example 1. Subsequently, an EL device emitting blue light was made according to the processes similar to Example 2. When a voltage of 8 V was applied to this EL device, the EL panel produced white light, and at this time, the external quantum efficiency was about 2.4%. As the results, even if inorganic, fluorescent substance having a lower fluorescence yield than that of organic, fluorescent substance was used, by dispersing the fine particles having a light scattering function in the light scattering portion, the efficiency of extracting light was accomplished to a comparative level as the case where only the organic, fluorescent substance was used (second comparative example). Also, seen from CIE chromaticity diagram values after continuous operation of 1000 hours, the chromaticity less deviated and brightness less decreased compared to the light emitting panel in Example 2. From the results, it was found that use of the inorganic, fluorescent substance could provide a light emitting panel that had less change in chromaticity, a smaller decrease in brightness and a higher endurance.

(Example 5)

A microfabricated film (quadrangular pyramid having a vertex angle of 90° and a pitch of 20 $\mu$m) was attached to the support substrate of the EL device manufactured similarly to Example 2 (FIG. 5). When a voltage of 8 V was applied to this EL device, the EL panel produced white light, and at this time, the external quantum efficiency was about 2.8%. From the results, it was found that further attaching the microfabricated film to the support substrate improved the efficiency of extracting a component of light that propagated in the substrate.

(Example 6)

A light scattering portion was formed by adding red, fluorescent pigments (rhodamine 6G from Sigma-Aldrich Co.) to the binder material containing the fine particles $TiO_2$ of Example 1 so that a square opening of 70 $\mu$m x 70 $\mu$m was formed with a frame having a width of 15 $\mu$m being left in the outer circumference, in a square of 100 $\mu$m $\times$ 100 $\mu$m at a pitch of 100 $\mu$m (FIG. 3). Subsequently, an EL device emitting blue light was made according to the processes similar to Example 2. When a voltage of 8 V was applied to this EL device, the EL panel produced white light, and at this time, the external quantum efficiency was about 2.6%. From the results, it was found that dispersing the fine particles having a light scattering function in the light scattering portion improved the efficiency of extracting light, and further forming the light scattering portion in the outer circumference of the light emitting medium more improved the efficiency of extracting light.

(Example 7)

A light scattering portion was formed according to the processes similar to Example 1, by adding red, fluorescent pigments (rhodamine 6G from Sigma-Aldrich Co.) to the binder material containing the fine particles $TiO_2$ of Example 1. Subsequently, an EL device emitting blue light was manufactured according to the processes similar to Example 2, but the second negative electrode was not formed on the light scattering portion. When a voltage of 8 V was applied to this EL device, the EL panel produced white light, and at this time, the external quantum efficiency was about 2.3%.

From the results, it was found that the case of providing the second electrode for forming a reflecting electrode on the light scattering portion (Example 2) brought out a better effect of extracting light due to the photon confinement effect.

(Example 8)

An inorganic EL device having a similar light scattering portion to that of Example 1 was manufactured, except that fluorescent substance in a luminescence center as a light emitting medium was $CaGa_2S_4$: Ce. When this EL device was operated at 8 V and 60 Hz, the external quantum efficiency was about 0.8%.

(Comparative Example 5)

An EL device was manufactured similarly to Example 8, but the light scattering portion did not contain the fine particles $TiO_2$. When this EL device was operated at 8 V and 60 Hz, the external quantum efficiency was about 0.6%.
From the results of Example 8 and Comparative Example 5, it was found that, even in the inorganic EL device, dispersing the fine particles having a light scattering function in the light scattering portion improved the efficiency of extracting light.

(Example 9)

An EL device was formed according to the processes similar to Example 2, except that the first electrode was a reflecting electrode having Cr deposited entirely on the support substrate and the second electrode was a transparent electrode made of ITO. When a voltage of 8 V was applied to this EL device, the EL panel produced white light, and at this time, the external quantum efficiency was about 2.3%. Comparing to Example 2, it was found that providing the reflective electrode to surround the trapezoidal, upper portion of the light scattering portion more improved the efficiency of extracting light.
Owing to the EL device and the EL panel of the present invention, especially to the organic EL apparatus, the efficiency of extracting light can be improved due to including the organic EL device according to the present invention described above, and further comparatively easy production can be realized. Such organic EL apparatus can realize, for example, various electronics such as an illumination light source and a backlight unit having low power consumption and high brightness, a TV that can display high-quality image, a mobile phone, an electronic notebook, PDA, an in-car monitor, a video recorder of viewfinder type or direct-vision monitor type, a video phone and a touch panel.

**Claims**

1.  An electroluminescent device, comprising:

    a support substrate;
    a light emitting portion in which a first electrode, a light emitting medium and a second electrode are laminated in this order or the inverse order on the support substrate; and
    a light scattering portion located at least on the side of the light emitting medium, containing a light scattering fine particle, or the light scattering fine particle and fluorescent substance, and having a tapered shape in which a distance from a center of the light emitting portion enlarges upward from the side of the support substrate,

    wherein, in the light emitting portion, the light emitting medium emits light by passing electrical current between the first electrode and the second electrode, and
    wherein light exiting from the light emitting medium and traveling in the direction different from a direction A of extracting light is incident on the light scattering portion and scattered, or is absorbed to emit and scatter light, thereby light is extracted from the light scattering portion in the direction A.

2.  The electroluminescent device according to claim 1,
    wherein the light emitting medium is formed to be in contact with a tapered surface of the light scattering portion.

3.  The electroluminescent device according to claim 1 or 2,
    wherein the light scattering portion is formed to sandwich in the light emitting medium in a stripe shape between the adjacent light scattering portions.

4.  The electroluminescent device according to claim 1 or 2,

wherein the light scattering portion is formed to surround the light emitting medium.

5. The electroluminescent device according to any of claims 1 to 4,
wherein the light scattering fine particle is a fine particle selected from the group of an inorganic oxide fine particle, an inorganic nitride fine particle, an inorganic oxynitride fine particle and a metal fine particle, and having average grain size of 100 to 400 nm.

6. The electroluminescent device according to any of claims 1 to 5,
wherein the light scattering portion is formed by dispersing only the light scattering fine particle in binder material.

7. The electroluminescent device according to any of claims 1 to 5,
wherein the light scattering portion is formed by dispersing the light scattering fine particle and the fluorescent substance in binder material.

8. The electroluminescent device according to claim 7,
wherein the light emitting medium is a blue light emitting medium,
the light scattering portion includes:

a first light scattering portion containing fluorescent substance for absorbing blue luminescence to produce green fluorescence; and
a second light scattering portion containing fluorescent substance for absorbing blue luminescence to produce red fluorescence.

9. The electroluminescent device according to claim 8,
wherein the first light scattering portion and the second light scattering portion are formed to sandwich alternately the light emitting medium.

10. The electroluminescent device according to claim 7,
wherein the fluorescent substance is an inorganic, fluorescent substance fine particle.

11. The electroluminescent device according to any one of claims 1 to 10,
wherein any one of the first electrode and the second electrode is a transparent electrode and the other is a reflecting electrode, and
wherein the reflecting electrode is formed to extend on the light scattering portion on the side opposite to the direction A of extracting light.

12. The electroluminescent device according to claim 11,
wherein a top of the light scattering portion is formed higher above an upper surface of the light emitting medium, and
wherein an upper portion of the light scattering portion higher above an upper portion of the light emitting medium is surrounded by the reflecting electrode.

13. The electroluminescent device according to any one of claims 1 to 12,
wherein the direction A of extracting light is a direction in which light is extracted from the side of the support substrate, and
wherein a microfabricated resin medium and/or a light scattering medium intervene in the support substrate and the surrounding of the atmosphere, and/or are situated at a position in contact with the support substrate.

14. The electroluminescent device according to any one of claims 1 to 12,
wherein the direction A of extracting light is a direction in which light is extracted from the opposite side of the support substrate, and
wherein a microfabricated resin medium and/or a light scattering medium intervene in the electroluminescent device and the surrounding of the atmosphere, on the electroluminescent device composed of the light emitting portion and the light scattering portion.

15. An electroluminescent panel, including the electroluminescent device according to any one of claims 1 to 14.

FIG. 1

FIG. 2

FIG. 3

FIG. 4

FIG. 5

FIG. 6

FIG. 7A

2

1

FIG. 7B

FIG. 7C

hν

PM

5

FIG. 7D

DM

3

FIG. 7E

FIG. 7F

4

Light emitting portion

4

5

3

5a/5b

2

B

1

A    A

FIG. 8

2

A

3

5

4    B    5a/5b

1

FIG. 9

FIG. 10

European Patent
Office

**EUROPEAN SEARCH REPORT**

Application Number

EP 07 07 5918

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2006/010355 A (NOVALED GMBH [DE]; BIRKNSTOCK JAN [DE]; VEHSE MARTIN [DE]; ROMAINCZYK) 2 February 2006 (2006-02-02) * figure 2 * | 1-15 | INV. H01L51/52 |
| X | US 2001/026124 A1 (LIU YACHIN [US] ET AL LIU YACHIN [US] ET AL) 4 October 2001 (2001-10-04) * claim 1 * | 1-15 | |
| X | US 2005/018431 A1 (SHIANG JOSEPH JOHN [US]) 27 January 2005 (2005-01-27) * figures 1A,8 * | 1-15 | |
| X | TOSHITAKA NAKAMURA ET AL: "Enhanced Coupling of Light from Organic Electroluminescent Device Using Diffusive Particle Dispersed High Refractive Index Resin Substrate" OPTICAL REVIEW, SPRINGER-VERLAG, BE, vol. 13, no. 2, 1 March 2006 (2006-03-01), pages 104-110, XP019353335 ISSN: 1349-9432 * figures 4,6 * | 1-15 | TECHNICAL FIELDS SEARCHED (IPC) H01L |
| X | IZUMI Y ET AL: "IMPROVING THE LIGHT OUT-COUPLING PROPERTIES OF INORGANIC THIN-FILM ELECTROLUMINESCENT DEVICES" JAPANESE JOURNAL OF APPLIED PHYSICS, JAPAN SOCIETY OF APPLIED PHYSICS, TOKYO, JP, vol. 41, no. 3A, PART 01, 1 March 2002 (2002-03-01), pages 1284-1287, XP001192127 ISSN: 0021-4922 * figures 1,4,5 * | 1-15 | |

The present search report has been drawn up for all claims

| Place of search | Date of completion of the search | Examiner |
|---|---|---|
| Munich | 6 May 2008 | Saldamli, Saltuk |

CATEGORY OF CITED DOCUMENTS

X : particularly relevant if taken alone
Y : particularly relevant if combined with another
　　document of the same category
A : technological background
O : non-written disclosure
P : intermediate document

T : theory or principle underlying the invention
E : earlier patent document, but published on, or
　　after the filing date
D : document cited in the application
L : document cited for other reasons

& : member of the same patent family, corresponding
　　document

EPO FORM 1503 03.82 (P04C01)

**ANNEX TO THE EUROPEAN SEARCH REPORT
ON EUROPEAN PATENT APPLICATION NO.**

EP 07 07 5918

This annex lists the patent family members relating to the patent documents cited in the above-mentioned European search report.
The members are as contained in the European Patent Office EDP file on
The European Patent Office is in no way liable for these particulars which are merely given for the purpose of information.

06-05-2008

| Patent document cited in search report | | Publication date | Patent family member(s) | | Publication date |
|---|---|---|---|---|---|
| WO 2006010355 | A | 02-02-2006 | CN | 101019250 A | 15-08-2007 |
| | | | DE 102004035965 A1 | | 08-06-2006 |
| | | | EP | 1771895 A2 | 11-04-2007 |
| | | | JP | 2008507809 T | 13-03-2008 |
| | | | KR | 20070044454 A | 27-04-2007 |
| | | | US | 2008048557 A1 | 28-02-2008 |
| US 2001026124 | A1 | 04-10-2001 | NONE | | |
| US 2005018431 | A1 | 27-01-2005 | EP | 1652242 A2 | 03-05-2006 |
| | | | JP | 2006528825 T | 21-12-2006 |
| | | | KR | 20060056343 A | 24-05-2006 |
| | | | WO | 2005018010 A2 | 24-02-2005 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006287397 A
- JP 11283751 A
- JP 2006107744 A
- JP 2005071920 A
- JP 6151061 A
- JP 2003303677 A

**Non-patent literature cited in the description**

- **TETSUO TSUTSUI.** Present Situation and Trend of Organic Electroluminescence. *Monthly DISPLAY,* September 1995, vol. 1 (3), 11
- **G. GU ; S. R. FORREST.** *Optics Lett,* 1997, vol. 22, 396